# EUROPEAN PATENT SPECIFICATION

(11) **EP 2 819 167 B1**
(45) Date of publication and mention of the grant of the patent: **10.01.2018**
(21) Application number: 14157667.8
(22) Date of filing: 04.03.2014
(51) Int. Cl.: H01L 27/02, G01T 1/17, H05F 3/00, H01L 27/146

(54) **Electrostatic protection structure for pixel unit and image sensor**
Elektrostatische Schutzstruktur für Pixeleinheit und Bildsensor
Structure de protection électrostatique pour unité de pixel et capteur d'image

(30) Priority: 28.06.2013 CN 201310270706
(43) Date of publication of application: 31.12.2014
(73) Proprietor: Shanghai Tianma Micro-electronics Co., Ltd., Pudong New District Shanghai 201201 (CN); Tianma Micro-Electronics Co., Ltd., Nanshan District Shenzhen Guangdong 518052 (CN)
(72) Inventor: Fei, Xiaolei, 201201 Shanghai (CN); Ling, Yan, 201201 Shanghai (CN); Zhu, Hong, 201201 Shanghai (CN); Qi, Gang, 201201 Shanghai (CN)
(74) Representative: Epping - Hermann - Fischer

(56) References cited:
- EP-A1- 2 477 171
- US-A1- 2005 078 232
- US-A1- 2005 190 168
- US-A1- 2008 224 179
- US-A1- 2010 328 916
- US-A1- 2011 317 318
- US-A1- 2012 211 772

## Description

### FIELD OF THE INVENTION

The present invention relates to the field of electrostatic protection, and in particular to an electrostatic protection structure which may prevent electrostatic damage and an image sensor using the electrostatic protection structure.

### BACKGROUND OF THE INVENTION

With the development of society and continuous progress of science and technology, kinds of digital imaging medical technologies emerge endlessly. Digital imaging technologies have played a very important role in the present medical field. In most of the existing digital imaging medical applications, such as the Chest X-ray and the Computerized Tomography (CT), an element which is crucial in the digital imaging technology is an X-ray sensor.

The operation principle of the X-ray sensor is as follows: a visible light is generated when an X-ray passes through a scintillator layer or a fluorescent layer, and the visible light is converted into a charge by a photodiode in a pixel unit. The charge is stored in the photodiode. A voltage is applied line by line to scan lines in a pixel array by an address control unit, thus pixel switches connected to the scan lines are turned on line by line. The charge stored in the photodiode is output to a data processing unit via a data line. The data processing unit may further process the obtained electrical signal. For example, the data processing unit may amplify and perform the analog-digital conversion on the obtained electrical signal. Finally, image information is obtained.

During the binding manufacturing process of the X-ray sensor, static electricity may enter a display area from the signal output terminal of the date line, thereby damaging a pixel unit in the display area.

US 2010/328916 A1 relates to a semiconductor device comprising a terminal electrode, a protection circuit, an integrated circuit and a wiring over a substrate. The wiring electrically connects the terminal electrode, the protection circuit and the integrated circuit. The protection circuit is provided between the terminal electrode and the integrated circuit. The terminal electrode, the protection circuit and the integrated circuit are connected to one another without causing the wiring to branch.

US 2008/224179 A1 describes a circuit comprising a CCD array on an integrated circuit substrate. The CCD array comprises a plurality of gate electrodes that are insulated from a substrate by an insulating layer. The gate electrodes are connected to a conductor bonded to said substrate. The circuit comprises a protection circuit on said substrate that is connected to said conductor and said substrate. The protection circuit has a first state in which said protection circuit provides an impedance greater than an operating impedance between said conductor and second substrate and a second state in which said protection circuit provides a shorting impedance between said conductor and said substrate. The protection circuit is in the first state if the potential on the conductor is in an operating range defined by a negative threshold potential and a positive threshold potential. The protection circuit is in the second state if said potential on said conductor is outside of said operating range.

US 2005/190168 A1 relates to a protection circuit of an LCD panel, comprising a display cell coupled between a data electrode, a gate electrode and a common electrode. The protection circuit comprises a switch comprising a first terminal and a second terminal, wherein the first terminal is coupled to at least the data electrode, the gate electrode or both. A switch is turned on when a voltage level of the first terminal or the second terminal exceeds a threshold voltage. The protection circuit further comprises an ESD protection circuit comprising a capacitive load and a resistive load, coupled between the second terminal and the common electrode.

US 2012/211772 A1 relates to an array substrate comprising a substrate comprising a display area and a peripheral area, the display area displaying an image, the peripheral area surrounding the display area. The array substrate further comprises a dummy pad extending along a first direction in the peripheral area, and comprising a first protrusion portion protruding from an end portion of the dummy pad along the first direction. The array substrate further comprises a driving signal output line to provide a driving signal, the driving signal output line extending along a second direction crossing with a first direction, and being disposed adjacent to the dummy pad.

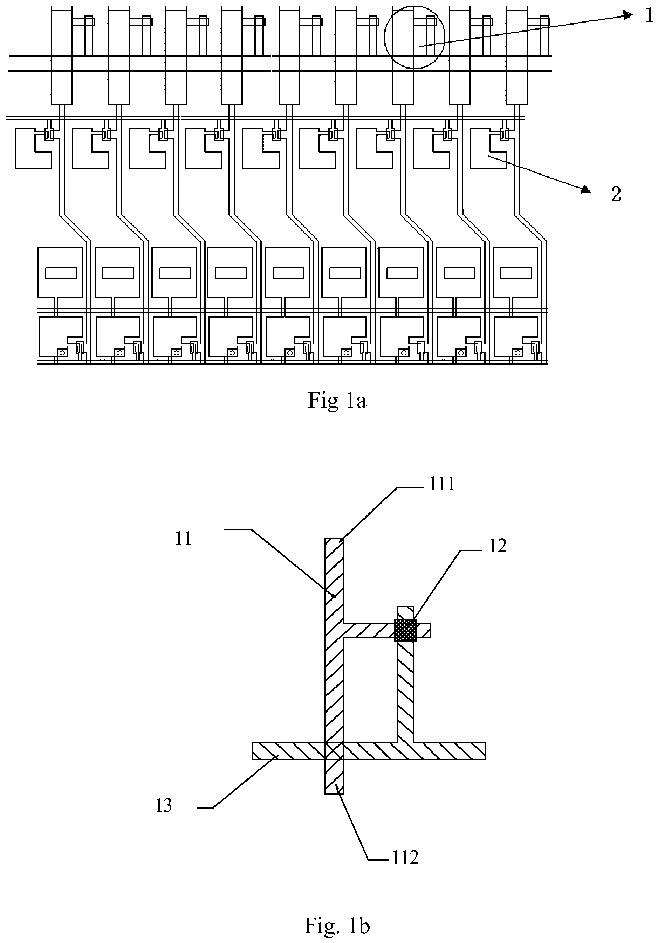

Figure 1a is a plan structural schematic diagram of an electrostatic protection structure in the existing X-ray image sensor, and Figure 1b is an enlarged diagram of the electrostatic capacitor protection structure in Figure 1a. Referring to Figure 1a and Figure 1b, the method for preventing the pixel unit from electrostatic damage applied in the prior art is as follows. A pixel (dummy pixel) protection electrode 2 is provided in the non-display area, and is in cooperation with an electrostatic protection capacitor structure 1 provided at a date line. The electrostatic protection capacitor structure 1 includes a data line 11 which includes a signal output terminal 111 and a pixel unit connection terminal 112. A pixel unit transmits a pixel signal to the signal output terminal 111 via the pixel unit connection terminal 112 and the data line 11. In addition, an electrostatic protection capacitor 12 is provided at a branch of the data line 11, and one terminal of the electrostatic protection capacitor 12 is connected to a constant potential. In this design, the static electricity is firstly desired to be diverted into the electrostatic protection capacitor. Moreover, if a part of the static electricity passes through the signal transmission path, the part of the static electricity may still be firstly transmitted into the pixel protection electrode 2, thus the pixel electrode in the display area is prevented from electrostatic damage. However, the effect of electrostatic protection is not ideal.

### SUMMARY OF THE INVENTION

In view of the above, the present invention provides an electrostatic protection structure for pixel unit and an image sensor.

An embodiment of the present invention provides an electrostatic protection structure. The electrostatic protection structure includes: a data line, adapted to transmit a pixel signal; wherein the data line comprises an electrostatic diverting path having a straight section and a signal transmission path having a bending section; one terminal of the signal transmission path is connected to a pixel unit, and the other terminal of the signal transmission path is connected to a signal output terminal, wherein the other terminal of the signal transmission path is adapted to output a signal from the pixel unit; at least one electrostatic protection capacitor is provided in the electrostatic diverting path; one plate of the electrostatic protection capacitor is connected to a constant potential via a wire in a gate electrode layer, and the other plate of the electrostatic protection capacitor is connected to the signal output terminal via a data line in the electrostatic diverting path; and the two plates of the electrostatic protection capacitor are respectively formed in a gate electrode layer and a source drain electrode layer, and an intermediate medium of the electrostatic protection capacitor is formed in an active layer; or the two plates of the electrostatic protection capacitor are respectively formed in the source drain electrode layer and a common electrode layer, and the intermediate medium of the electrostatic protection capacitor is formed in a passivation layer; the signal transmission path and the electrostatic diverting path are made of materials with different resistivities; wherein the impedance of the signal transmission path is greater than the impedance of the electrostatic diverting path. An embodiment of the present invention provides an X-ray image sensor. The X-ray image sensor includes the above-mentioned electrostatic protection structure, and further includes multiple pixel units. The electrostatic protection structure is connected to the pixel unit.

The advantages or beneficial effects of the embodiments of the present invention are as follows.

In the present invention, the data line connected to the pixel unit has two portions, namely, the signal transmission path and the electrostatic diverting path. One terminal of the signal transmission path is connected to the pixel unit, and the other terminal of the signal transmission path is connected to the signal output terminal. One terminal of the electrostatic diverting path is connected to the signal output terminal, and the other terminal of the electrostatic diverting path is connected to the constant potential. Moreover, the impedance of the signal transmission path is provided to be greater than the impedance of the electrostatic diverting path, so that static electricity can be directly diverted out via the electrostatic diverting path when the static electricity flows into the data line from the signal output terminal, thereby protecting the pixel unit connected to the signal transmission path from the electrostatic damage.

### BRIEF DESCRIPTION OF THE DRAWINGS

In order to explain the technical solutions in embodiments of the present invention more clearly, drawings accompanying the embodiments are briefly illustrated hereinafter. Apparently, the accompanying drawings described hereinafter are only for some embodiments of the present invention, and those skilled in the art can further conceive other drawings according to the drawings without creative work.
Figure 1a is a schematic top view of an electrostatic protection structure in a X-ray image sensor in the prior art;
Figure 1b is an enlarged diagram of the electrostatic capacitor protection structure in Figure 1a.
Figure 1c is an equivalent circuit diagram of the electrostatic protection structure shown in Figure 1b;
Figure 2 is a schematic diagram of an electrostatic protection structure in an X-ray image sensor according to a first embodiment of the present invention; and
Figure 3 is a schematic diagram of an electrostatic protection structure in an X-ray image sensor according to a second embodiment of the present invention.

### DETAILED DESCRIPTION OF THE INVENTION

The technical solutions according to the embodiments of the present invention will be described clearly and completely as follows in conjunction with the accompany drawings in the embodiments of the present invention. It is clear that the described embodiments are only a part of the embodiments according to the present invention, but not all of the embodiments according to the present invention.

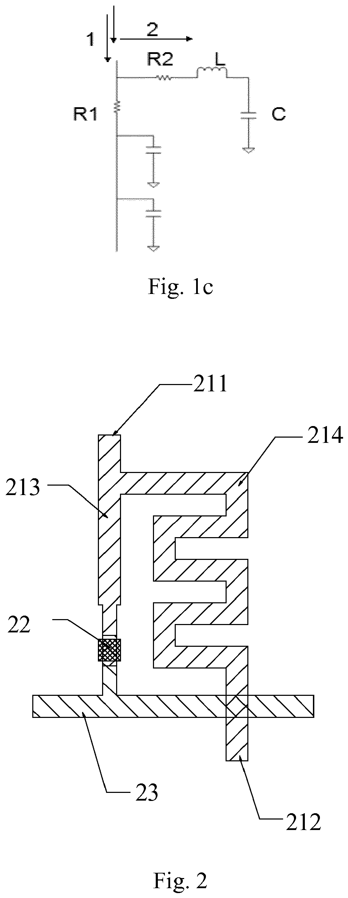

Figure 1c shows an equivalent circuit diagram of an electrostatic protection structure in the prior art shown in Figure 1b. A path 1 is a signal transmission path and a path 2 is an electrostatic diverting path. The equivalent impedance of the path 1 is a line resistance R1 of the data line, and the equivalent impedance of the path 2 is the sum of a line resistance R2 of the data line and an additional inductive impedance and capacitive impedance which are generated due to the bending of the path 2. Thus, the equivalent impedance of the path 2 is greater than the equivalent impedance of the path 1. It is discovered by the inventor of the present invention after numerous experiments that: even if an electrostatic protection capacitor 12 is provided and a pixel protection electrode 2 is added, in the case where the static electricity flows into the data line, the overlapping portion between a common electrode and the data line in the outermost region of the display area, rather than the electrostatic protection capacitor 12 and the pixel protection electrode 2, may firstly suffer from the electrostatic breakdown, thereby causing the data line to be broken and affecting the normal operation of the X-ray image sensor. To this, the applicant proposes the following solution. The impedance of the signal transmission path is provided to be greater than the impedance of the electrostatic diverting path in the data line, thus even if the static electricity flows into the data line during the binding manufacturing process of the X-ray image sensor, the static electricity may still be preferentially diverted out via the electrostatic diverting path, thereby preventing the operating circuit from the electrostatic damage.

The embodiments of the present invention are described below in conjunction with the accompanying drawings. Figure 2 is a schematic diagram of an electrostatic protection structure in an X-ray image sensor according to a first embodiment of the present invention. The electrostatic protection structure includes a data line. The data line includes a signal transmission path 214 and an electrostatic diverting path 213. The data line includes a pixel unit connection terminal 212 and a signal output terminal 211. One terminal of the signal transmission path 214 is connected to the pixel unit via the pixel unit connection terminal 212, and the other terminal of the signal transmission path 214 is connected to the signal output terminal 211. One terminal of the electrostatic diverting path 213 is connected to the signal output terminal 211, and the other terminal of the electrostatic diverting path 213 is connected to a constant potential, to divert static electricity. In order to ensure that the static electricity can be diverted via the electrostatic diverting path 213, the impedance of the electrostatic diverting path 213 is provided to be less than that of the signal transmission path 214 in the present invention.

In one embodiment, the electrostatic diverting path 213 includes a straight section, and the signal transmission path 214 includes a bending section. When static electricity is generated, the impedance of the bending section is equivalent to the sum of linear resistance and the inductive impedance (2πfL) generated due to the bending, and the impedance of the straight section only includes the linear resistance. Therefore, the impedance of the electrostatic diverting path 213 being less than the impedance of the signal transmission path 214 is realized.

It should be noted that, although the inductance impedance generated due to the bending of the path is less in the case of the normal operation, the additional inductive impedance caused by the high frequency characteristic of the extremely short discharge time is not ignorable in the case of instant electrostatic discharge.

Furthermore, an electrostatic protection capacitor 22 is provided in the electrostatic diverting path 213. One plate of the electrostatic protection capacitor 22 is connected to a constant potential via a wire 23, to divert the static electricity to the constant potential. The other plate of the electrostatic protection capacitor 22 is connected to the signal output terminal 211 via a data line in the electrostatic diverting path 213, to further reduce the impedance of the electrostatic diverting path 213. In one embodiment, the wire 23 is a wire in a gate electrode layer. The constant potential may be the ground potential, that is to say, one plate of the electrostatic protection capacitor 22 may be connected to the signal output terminal 211 of the data line, and the other plate of the electrostatic protection capacitor 22 may be grounded via the wire 23.

It should be noted that, multiple electrostatic protection capacitors 22 may be connected in parallel in the electrostatic diverting path 213 as required, to avoid a failure of the electrostatic protection structure caused by a uniquely provided electrostatic protection capacitor being broken down by the static electricity. By providing the multiple electrostatic protection capacitors in parallel, the efficacy of the electrostatic protection structure may be effectively improved.

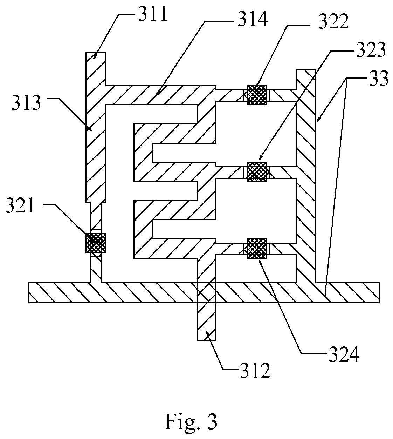

Figure 3 shows a schematic diagram of an electrostatic protection structure in an X-ray image sensor according to a second embodiment of the present invention. In the present embodiment, a signal transmission path 314 includes 9 bending points, that is to say, the signal transmission path 314 is connected to a pixel unit via a pixel unit connection terminal 312 after 9 times of bending. In the present embodiment, electrostatic protection capacitors 322, 323 and 324 are provided at the different bending points of the signal transmission path 314 respectively. Similar to an electrostatic protection capacitor 321 provided in an electrostatic diverting path 313, the electrostatic protection capacitors 322, 323 and 324 are connected to a constant potential. In one embodiment, one plate of one or more of the electrostatic protection capacitors 321, 322, 323 and 324 is connected to a constant potential via a wire 33 located in the same layer as a gate electrode. The constant potential may be the ground potential to divert the static electricity to a ground terminal.

Similar to the above-mentioned embodiment, multiple electrostatic protection capacitors may be provided in the electrostatic diverting path, which are respectively connected in parallel with the electrostatic protection capacitors 321, 322, 323 and 324, to further improve the efficiency of electrostatic protection. According to the invention, the signal transmission path portion and the electrostatic diverting path portion of the data line are made of materials with different resistivities to achieve the fact that the impedance of the signal transmission path is greater than the impedance of the electrostatic diverting path. An electrostatic protection capacitor is provided in the electrostatic diverting path to further reduce the impedance of the electrostatic diverting path, thus more static electricity is transmitted to the electrostatic diverting path, thereby reducing the damage to a working component due to the static electricity passing through the signal transmission path.

In one embodiment, two plates of the electrostatic protection capacitor according to various embodiments of the present invention are a gate electrode layer and a source drain electrode layer respectively, and the intermediate medium of the electrostatic protection capacitor is an active layer. The material of the active layer is an amorphous silicon film.

In another embodiment, two plates of the electrostatic protection capacitor according to various embodiments of the present invention are a source drain electrode layer and a common electrode layer respectively, and the intermediate medium of the electrostatic protection capacitor is a passivation layer. The material of the common electrode layer is Indium Tin Oxide (ITO) and the material of the passivation layer is SiNx.

Furthermore, the electrostatic protection capacitor provided by an embodiment of the present invention may further include a dummy pixel protection unit. The dummy pixel protection unit is provided between the signal transmission path and the pixel unit, to further ensure the electrostatic protection.

In addition, an embodiment of the present invention further provides an X-ray image sensor including the above-mentioned electrostatic protection structure. The X-ray image sensor further includes multiple pixel units. The electrostatic protection structure is connected to a pixel unit in a display area of the X-ray image sensor, and the signal output from the pixel unit is output via the electrostatic protection structure. During the manufacturing process of the X-ray image sensor, in the case where the static electricity enters from the signal output terminal, the static electricity is diverted out by the electrostatic protection structure, thereby preventing the pixel unit or other component from electrostatic damage. It should be noted that, one electrostatic protection structure may be connected to multiple pixel units, and alternatively one electrostatic protection structure may be connected to one pixel unit.

The advantages or beneficial effects of embodiments of the present invention are as follows.

The data line connected to the pixel unit has two portions, namely, the signal transmission path and the electrostatic diverting path. One terminal of the signal transmission path is connected to the pixel unit, and the other terminal of the signal transmission path is connected to the signal output terminal. One terminal of the electrostatic diverting path is connected to the signal output terminal, and the other terminal of the electrostatic diverting path is connected to the constant potential. Moreover, the impedance of the signal transmission path is provided greater than that of the electrostatic diverting path, thus the static electricity can be directly diverted out via the electrostatic diverting path in the case where the static electricity flows into the data line from the signal output terminal, thereby protecting the pixel unit connected to the signal transmission path from the electrostatic damage.

The embodiments described above are not for limiting the scope of protection of the technical solution.

## Claims

1. An electrostatic protection structure, comprising:
a data line, adapted to transmit a pixel signal; wherein
the data line comprises an electrostatic diverting path (213) having a straight section and a signal transmission path (214) having a bending section;
one terminal (212) of the signal transmission path is connected to a pixel unit, and the other terminal of the signal transmission path is connected to a signal output terminal (211), wherein the other terminal of the signal transmission path is adapted to output a signal from the pixel unit;
at least one electrostatic protection capacitor (22) is provided in the electrostatic diverting path;
one plate of the electrostatic protection capacitor is connected to a constant potential via a wire (23) in a gate electrode layer; and the other plate of the electrostatic protection capacitor is connected to the signal output terminal via a data line in the electrostatic diverting path; and
the two plates of the electrostatic protection capacitor are respectively formed in a gate electrode layer and a source drain electrode layer, and an intermediate medium of the electrostatic protection capacitor is formed in an active layer; or
the two plates of the electrostatic protection capacitor are respectively formed in the source drain electrode layer and a common electrode layer, and the intermediate medium of the electrostatic protection capacitor is formed in a passivation layer;
the signal transmission path and the electrostatic diverting path are made of materials with different resistivities; wherein the impedance of the signal transmission path is greater than the impedance of the electrostatic diverting path.

2. The electrostatic protection structure according to claim 1, wherein the bending section comprises a plurality of bending points.

3. The electrostatic protection structure according to claim 2, wherein at least one electrostatic protection capacitor is provided at each of the bending points of the bending section.

4. The electrostatic protection structure according to any of claims 1-3, wherein the electrostatic protection structure further comprises a dummy pixel protection unit, and the dummy protection pixel unit is connected between the signal transmission path and the pixel unit.

5. An X-ray image sensor, comprising the electrostatic protection structure according to any of claims 1-4, and further comprising a plurality of pixel units, wherein the electrostatic protection structure is connected to the pixel unit.

## Patentansprüche

1. Elektrostatische Schutzanordnung, aufweisend:
eine Datenleitung, die dazu angepasst ist, ein Pixelsignal zu übertragen; wobei
die Datenleitung einen elektrostatischen Ableitungspfad (213) mit einem geraden Abschnitt und einen Signalübertragungspfad (214) mit einem Abwinklungsabschnitt aufweist;
ein Anschluss (212) des Signalübertragungspfads an eine Pixeleinheit angeschlossen ist, und der andere Anschluss des Signalübertragungspfads an einen Signalausgangsanschluss (211) angeschlossen ist,
wobei der andere Anschluss des Signalübertragungspfads dazu angepasst ist, ein Signal von der Pixeleinheit auszugeben;
mindestens ein elektrostatischer Schutzkondensator (22) im elektrostatischen Ableitungspfad vorgesehen ist;
eine Platte des elektrostatischen Schutzkondensators über einen Draht (23) in einer Gate-Elektrodenschicht an ein konstantes Potential angeschlossen ist; und die andere Platte des elektrostatischen Schutzkondensators über eine Datenleitung im elektrostatischen Ableitungspfad an den Signalausgangsanschluss angeschlossen ist; und
die beiden Platten des elektrostatischen Schutzkondensators in einer Gate-Elektrodenschicht bzw. einer Source/Drain-Elektrodenschicht gebildet sind und ein Zwischenmedium des elektrostatischen Schutzkondensators in einer aktiven Schicht gebildet ist; oder
die beiden Platten des elektrostatischen Schutzkondensators in der Source/Drain-Elektrodenschicht bzw. einer gemeinsamen Elektrodenschicht gebildet sind und das Zwischenmedium des elektrostatischen Schutzkondensators in einer Passivierungsschicht gebildet ist;
der Signalübertragungspfad und der elektrostatische Ableitungspfad aus Materialien mit unterschiedlichen Widerstandswerten bestehen; wobei die Impedanz des Signalübertragungspfads größer ist als die Impedanz des elektrostatischen Ableitungspfads.

2. Elektrostatische Schutzanordnung nach Anspruch 1, wobei der Abwinklungsabschnitt mehrere Abwinklungspunkte aufweist.

3. Elektrostatische Schutzanordnung nach Anspruch 2, wobei an jedem Abwinklungspunkt des Abwinklungsabschnitts mindestens ein elektrostatischer Schutzkondensator vorgesehen ist.

4. Elektrostatische Schutzanordnung nach einem der Ansprüche 1-3, wobei die elektrostatische Schutzanordnung darüber hinaus eine Dummy-Pixelschutzeinheit aufweist, und die Dummy-Pixelschutzeinheit zwischen dem Signalübertragungspfad und der Pixeleinheit angeschlossen ist.

5. Röntgenstrahl-Bildsensor, der die elektrostatische Schutzanordnung nach einem der Ansprüche 1-4 und darüber hinaus mehrere Pixeleinheiten aufweist, wobei die elektrostatische Schutzanordnung an die Pixeleinheit angeschlossen ist.

## Revendications

1. Structure de protection électrostatique, comprenant :
une ligne de données, apte à transmettre un signal de pixel ; sachant que
la ligne de données comprend un chemin de déviation électrostatique (213) présentant une section droite et un chemin de transmission de signal (214) présentant une section de courbure ;
une borne (212) du chemin de transmission de signal est connectée à une unité de pixel, et
l'autre borne du chemin de transmission de signal est connectée à une borne de sortie de signal (211),
sachant que l'autre borne du chemin de transmission de signal est apte à sortir un signal de l'unité de pixel ;
au moins un condensateur de protection électrostatique (22) est prévu dans le chemin de déviation électrostatique ;
une plaque du condensateur de protection électrostatique est connectée à un potentiel constant via un fil (23) dans une couche d'électrode grille ; et l'autre plaque du condensateur de protection électrostatique est connectée à la borne de sortie de signal via une ligne de données dans le chemin de déviation électrostatique ; et
les deux plaques du condensateur de protection électrostatique sont respectivement formées dans une couche d'électrode grille et une couche d'électrode drain-source, et un fluide intermédiaire du condensateur de protection électrostatique est formé dans une couche active ; ou
les deux plaques du condensateur de protection électrostatique sont respectivement formées dans la couche d'électrode drain-source et une couche d'électrode commune, et le fluide intermédiaire du condensateur de protection électrostatique est formé dans une couche de passivation ;
le chemin de transmission de signal et le chemin de déviation électrostatique sont composés de matériaux ayant des résistivités différentes ; sachant que l'impédance du chemin de transmission de signal est supérieure à l'impédance du chemin de déviation électrostatique.

2. La structure de protection électrostatique selon la revendication 1, sachant que la section de courbure comprend une pluralité de points de courbure.

3. La structure de protection électrostatique selon la revendication 2, sachant qu'au moins un condensateur de protection électrostatique est prévu à chacun des points de courbure de la section de courbure.

4. La structure de protection électrostatique selon l'une quelconque des revendications 1 à 3, sachant que la structure de protection électrostatique comprend en outre une unité de protection de pixel factice, et l'unité de protection de pixel factice est connectée entre le chemin de transmission de signal et l'unité de pixel.

5. Capteur d'image à rayons X, comprenant la structure de protection électrostatique selon l'une quelconque des revendications 1 à 4, et comprenant en outre une pluralité d'unités de pixel, sachant que la structure de protection électrostatique est connectée à l'unité de pixel.
